# FASCICULE DE BREVET EUROPEEN

(11) **EP 0 660 400 B1**
(45) Date de publication et mention de la délivrance du brevet: **20.06.2001**
(21) Numéro de dépôt: 94402931.3
(22) Date de dépôt: 19.12.1994
(51) Int. Cl.: H01L 23/373

(54) **Elément de transfert thermique, utilisable notamment en électronique comme support de circuit imprimé ou de composant et son procédé de fabrication**
In der Elektronik als Träger gedruckter Schaltungen oder Bauelemente verwendbares Wärmeleitungselement und Herstellungsverfahren dafür
Thermoconductive element, usable in electronics as a support of a printed circuit or a component and its method of fabrication

(30) Priorité: 20.12.1993 FR 9315296
(43) Date de publication de la demande: 28.06.1995
(73) Titulaire: AEROSPATIALE MATRA, 75016 Paris (FR)
(72) Inventeur: Cornec, Ludovic, F-24100 Bergerac (FR)
(74) Mandataire: Dubois-Chabert, Guy

(56) Documents cités:
- EP-A- 0 009 978
- EP-A- 0 552 475
- FR-A- 2 545 987
- FR-A- 2 546 878
- US-A- 4 689 276
- US-A- 5 070 040

## Description

La présente invention a pour objet un élément de transfert thermique, utilisable pour évacuer rapidement la chaleur produite par diverses sources de chaleur telles que des composants électroniques, des radiateurs, des batteries, des antennes, etc., notamment en électronique, en particulier dans le domaine spatial et aéronautique pour l'électronique embarquée.

Cet élément peut se présenter sous différentes formes. Ainsi, il peut avoir la forme d'un panneau ou d'une plaque, et être utilisé par exemple comme support de composants électroniques ou comme drain thermique pour support de circuit imprimé. Il peut aussi avoir la forme d'un boîtier hermétique ou non destiné à contenir divers dispositifs, par exemple des composants électroniques. Un tel élément est utile dans toute application nécessitant une forte conductivité thermique et/ou une grande stabilité dimensionnelle.

Lorsque cet élément est utilisé comme support de composants électroniques, ces derniers peuvent être des circuits intégrés, des circuits imprimés, des transistors de puissance, des diodes lasers, des microprocesseurs et plus généralement tout système électronique utilisé comme générateur de puissance, dispositif de stockage de courant ou générateur de signaux.

Pour certains systèmes électroniques, notamment destinés au domaine spatial et aéronautique, il existe certaines contraintes de compacité, de fiabilité et de légèreté qui paraissent difficilement conciliables. De plus, on est poussé à accroître les vitesses de fonctionnement et les capacités des systèmes par un facteur multiplicatif de 2 à 10, tout en réduisant la masse et le volume d'un facteur 2 à 4, et en augmentant par ailleurs la durée de vie des systèmes.

L'amélioration des performances s'accompagne souvent d'une miniaturisation, d'une densification et de vitesses d'horloge plus élevées, ce qui conduit à une production accrue de chaleur. Ainsi, dans le cas de circuits contenant jusqu'à 10⁶ portes, la dissipation de chaleur peut être de 30W par composant et l'on peut atteindre des dissipations de chaleur supérieures à 100W par composant dans les microprocesseurs. Cette génération de chaleur tend à augmenter la température de fonctionnement des systèmes, ce qui est néfaste pour leurs performances. En effet, le temps de réponse des systèmes augmente avec la température, ce qui peut conduire à un allongement du temps de réponse inacceptable lorsque des milliers d'opérations sont en jeu.

De façon similaire la puissance de sortie que l'on trouve sur des transistors de puissance à micro-ondes et des diodes lasers est telle que les performances et la fiabilité des composants ne sont limitées que par leur capacité à évacuer la chaleur.

Aussi, il est très important d'associer à ces composants électroniques des systèmes capables d'évacuer rapidement la chaleur qu'ils produisent, pour améliorer la fiabilité des composants, accroître leur durée de vie et réduire les coûts de fonctionnement. Ces systèmes doivent être capables de transférer rapidement la chaleur du composant lui-même à un puits thermique situé plus ou moins loin.

Les composants sont généralement assemblés sur des couches de circuits imprimés qui assurent les connexions électriques entre composants. La chaleur dégagée par les composants tend à dilater la couche contenant les pistes de circuits imprimés. Ceci peut provoquer la rupture des contacts composant-circuit par dilatation différentielle car le composant est généralement encapsulé dans un matériau dont le coefficient de dilatation thermique est inférieur à celui des couches de circuits imprimés.

Il est donc intéressant d'assembler intimement les couches de circuit sur un matériau-support ayant un coefficient de dilatation thermique égal ou légèrement inférieur à celui des composants. Dans ces conditions, l'ensemble couches de circuit-support a alors un coefficient de dilatation thermique très inférieur à celui des couches de circuits seules.

Il est aussi nécessaire d'associer les composants électroniques à des moyens permettant d'assurer leur support, leur protection contre l'environnement, l'évacuation des charges électriques ainsi que leur protection contre les rayonnements électromagnétiques.

Les moyens de support utilisés actuellement pour ces composants comme les supports en Kovar®, en alumine ou en colaminé Cu-Mo-Cu et Cu, Invar, Cu sont difficilement capables de remplir simultanément toutes ces fonctions.

On connaît toutefois par le document EP-A- 0 450 968 un support de circuit capable d'évacuer la chaleur générée par ce circuit, qui utilise dans ce but un matériau comprenant des particules de diamant ou de nitrure de bore cubique dispersées dans une matrice polymère, métallique ou céramique. Ce matériau peut se présenter sous la forme d'une feuille rigide ou flexible se supportant d'elle-même. Ainsi, il permet d'évacuer la chaleur générée par le composant tout en assurant son support, mais il ne remplit pas d'autres fonctions.

Le document EP-A-0 009 978 illustre un circuit intégré associé à une couche d'alumine et à un puits de chaleur formé d'une structure composite comprenant des fibres de carbone noyées dans une matrice métallique en cuivre.

Le document US-A-5 070 040 décrit des moyens de refroidissement de circuits intégrés comprenant un film de diamant synthétique en contact avec un fluide de refroidissement, pour transférer la chaleur du circuit à un fluide de refroidissement.

La présente invention a pour objet'un élément de transfert thermique de structure différente, qui lorsqu'il est utilisé comme support pour composant(s) électronique(s), permet d'assurer un transfert très rapide de la chaleur dégagée par le composant, et présente de plus des propriétés améliorées en ce qui concerne la dilatation thermique, la masse du support, la rigidité, la stabilité au vieillissement et la stabilité chimique. Par ailleurs, cet élément peut assurer d'autres fonctions (par exemple, mise à la terre) que celle consistant à transférer la chaleur dégagée par le composant.

Selon l'invention, l'élément de transfert thermique de la chaleur produite par une source de chaleur comprend au moins un ensemble formé d'une âme en matériau composite à matrice métallique renforcée par des fibres inorganiques sur laquelle est disposé un film de diamant, le film de diamant étant sur la surface de l'élément destinée à être en contact avec la source de chaleur.

Avantageusement, le film de diamant a une épaisseur de 0,25 à 150 µm, de préférence de 1 à 50 µm.

De préférence, chaque ensemble comprend de plus une couche d'accrochage intercalée entre l'âme et le film de diamant.

La couche d'accrochage est réalisée en une substance facilitant la liaison entre le diamant et la matrice métallique. Cette substance pourra préférentiellement favoriser des liaisons atomiques avec le diamant. Cette substance peut être un métal comme le titane.

Dans l'élément de l'invention, le fait d'associer une âme en matériau composite à un film de diamant permet d'obtenir, d'une part, des propriétés de stabilité et de résistance mécanique élevées dues au choix du matériau composite et, d'autre part, un transfert thermique très rapide dû aux conductivités thermiques élevées du diamant et du matériau composite à fibres inorganiques.

En effet, le matériau composite présente une conductivité thermique plus élevée que celle du métal constituant sa matrice métallique, en raison de la présence des fibres de renfort, et l'utilisation de diamant sous la forme d'un film continu permet d'assurer un transfert très rapide de la chaleur dégagée par une source de chaleur telle qu'un composant électronique.

Par ailleurs, le matériau composite est stable dimensionnellement, car son coefficient de dilatation est très faible, il est inerte chimiquement et présente des propriétés mécaniques élevées.

Dans ce matériau composite, on peut utiliser comme matrice métallique un métal à l'état pur ou sous la forme d'alliage ou de composé intermétallique. On utilise de préférence des métaux légers tels que l'aluminium, le magnésium, le cuivre, le titane, leurs alliages et leurs composés intermétalliques, notamment l'aluminium et ses alliages, et le magnésium ainsi que ses alliages. Les composés intermétalliques utilisables sont par exemple les composés AlNi, TiAl.

Les fibres inorganiques utilisées comme renfort du matériau composite peuvent être des fibres d'alumine ou des fibres de carbone fortement graphitées, en particulier des fibres de haute résistance à la rupture (HR), de haut module d'élasticité (HM) ou de très haut module d'élasticité (THM). Elles peuvent être obtenues à partir de divers matériaux carbonés, par exemple à partir d'un précurseur polyacrylonitrile ou à partir de brai mésophasique.

De préférence, on utilise les fibres les plus graphitées, par exemple les fibres THM telles que les fibres TONEN FT 700 qui présentent les caractéristiques suivantes :
- diamètre de fibres : 10µm,
- masse volumique : 2,16g/cm³,
- résistance à la rupture : 3300 MPa,
- module d'Young : 700 GPa, et
- coefficient de dilatation : -1,5 . 10⁻⁶/°C.

On peut aussi utiliser des fibres d'alumine d'un diamètre d'environ 20 µm qui présentent les caractéristiques suivantes :
masse volumique : 3,9 g/cm³
résistance à la rupture : 2068 MPa
module d'Young : 300 GPa.

On peut encore utiliser des fibres d'alumine-silice ayant les caractéristiques suivantes :
masse volumique : 3,5 g/cm³
résistance à la rupture : 1000 MPa
module d'Young : 100 GPa, et
coefficient de dilatation : 0,93.10⁻⁶/°C.

Le renfort peut se présenter sous différentes formes. Ainsi, il peut comprendre au moins une mèche cylindrique constituée de 100 à 10 000 filaments ayant un diamètre moyen d inférieur à 50µm (et généralement voisin de 10 µm).

Il peut encore être formé d'une ou plusieurs nappes unidirectionnelles obtenues chacune par étalement et/ou juxtaposition d'une ou plusieurs mèches de fibres ayant un diamètre moyen d inférieur à 50µm.

Dans le cas où l'on utilise plusieurs nappes unidirectionnelles, le renfort peut être formé d'un empilement de ces nappes éventuellement croisées.

Le renfort peut encore être constitué par une préforme bidimensionnelle ou tridimensionnelle obtenue par des techniques classiques de tissage.

On peut également réaliser une préforme de fibres de renfort, puis l'infiltrer par les techniques habituelles de revêtement sous pression, d'infiltration moyenne pression ou de fonderie basse pression.

Généralement, le renfort représente 20 à 70 % en volume du matériau composite.

Cette proportion est choisie en fonction des propriétés que l'on veut obtenir.

Dans ce matériau composite, les fibres inorganiques sont de préférence sous la forme de mèches cylindriques, constituées de 100 à 10 000 fibres, ayant un diamètre moyen d généralement compris entre 30 µm et 3 mm.

De préférence, on utilise comme matrice métallique l'aluminium, le magnésium ou leurs alliages car ce sont des matériaux très légers, notamment le magnésium qui a une densité de 1,74 g/cm⁺³ bien inférieure à celle de l'aluminium (2,7 g/cm⁺³).

Selon une variante de réalisation de l'invention, l'élément de transfert thermique peut comprendre de plus un substrat métallique associé à un ou plusieurs ensembles formés de l'âme en matériau composite et du film de diamant. Ce substrat peut être réalisé par exemple en le même métal que l'âme du matériau composite.

Le substrat peut être disposé soit au-dessous du ou des ensembles, soit entre deux ensembles, soit sur la périphérie de l'élément de transfert thermique.

L'invention a également pour objet un procédé de fabrication d'un élément de transfert thermique répondant aux caractéristiques précitées.

Selon ce procédé, on forme chaque ensemble par dépôt chimique en phase vapeur d'un film de diamant sur une âme en matériau composite à matrice métallique renforcée par des fibres inorganiques.

Ce mode de dépôt du film de diamant permet d'obtenir un film mince continu d'épaisseur faible, par exemple de 1 à 50 µm d'épaisseur, présentant des propriétés satisfaisantes, en particulier une conductivité thermique élevée, une résistivité électrique très grande et un coefficient de dilatation très faible.

Généralement, avant d'effectuer le dépôt chimique en phase vapeur du film de diamant, on réalise sur l'âme en matériau composite une couche d'accrochage, par exemple en titane.

Lorsque l'élément comprend plusieurs ensembles formés d'une âme en matériau composite et d'un film de diamant, ceux-ci peuvent être assemblés par brasage ou soudage par diffusion du film de diamant d'un ensemble sur l'âme de l'ensemble adjacent.

L'âme en matériau composite de départ peut être préparé par les procédés classiques utilisés habituellement pour la réalisation de matériaux composites à matrice métallique.

A titre d'exemple d'un tel procédé, on peut citer celui comprenant les étapes suivantes :
a) réalisation d'un semi-produit préimprégné de métal par étalement de mèches de fibres de carbone graphitées et métallisation de cette mèche par dépôt physique en phase vapeur,
b) réalisation d'une préforme à partir du semi-produit préimprégné, et
c) consolidation à chaud sous pression et sous atmosphère contrôlée de la préforme ainsi obtenue.

La consolidation à chaud peut être effectuée par compression isostatique à une température de 400 à 700°C, sous une pression de 5 à 100 MPa, en atmosphère d'argon.

D'autres caractéristiques et avantages de l'invention apparaîtront mieux à la lecture de la description qui suit, donnée bien entendu à titre illustratif et non limitatif, en référence aux figures annexées sur lesquelles :
- la figure 1 représente en coupe verticale un support pour composants électroniques constitué par un élément de transfert thermique sous la forme de panneau conforme à l'invention ;
- la figure 2 représente schématiquement en coupe verticale une variante de réalisation de l'élément de transfert thermique de la figure 1 ; et
- la figure 3 représente schématiquement en coupe verticale un autre mode de réalisation de l'élément de transfert thermique de l'invention.

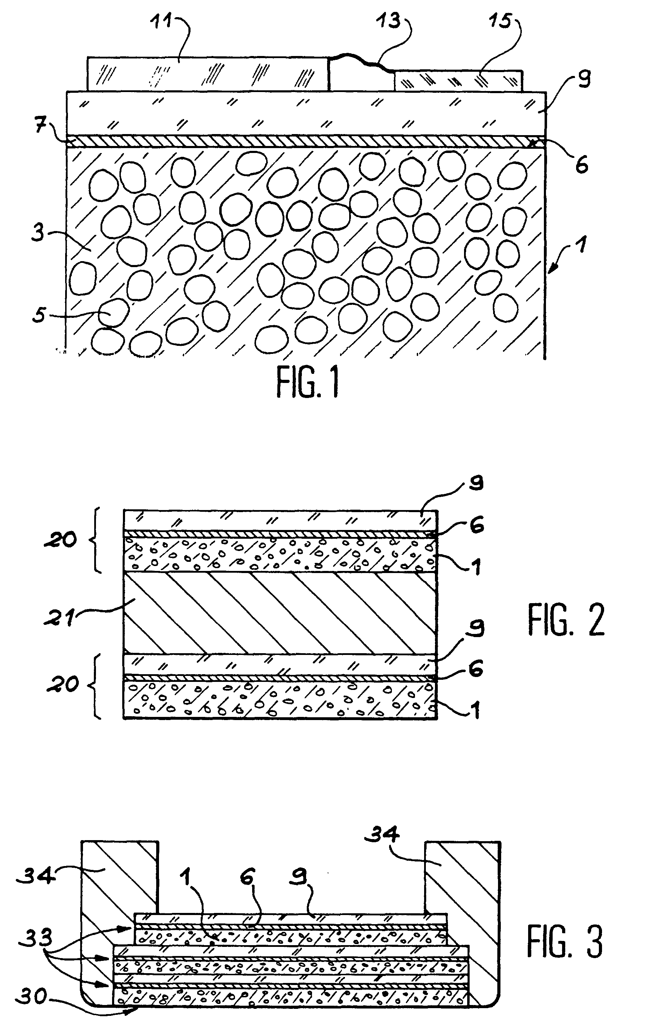

Sur la figure 1, on voit que le support comprend une âme 1 en matériau composite à matrice métallique 3 renforcée par des fibres de carbone 5. Sur la surface 6 de l'âme qui sera destinée à être en contact avec le composant électronique, sont disposés successivement une couche d'accrochage 7 réalisée par exemple en titane et un film 9 de diamant.

Ce support est réalisé de la façon suivante.

Tout d'abord, on prépare l'âme en matériau composite à partir de fibres de carbone à très haut module (THM) constitué par les fibres TONEN présentant les caractéristiques données ci-dessus. Dans ce but, on étale les mèches de fibres et on dépose sur celles-ci par dépôt physique en phase vapeur du magnésium de façon à obtenir un semi-produit préimprégné. On dispose ensuite les fibres imprégnées de façon à leur donner une forme de plaque proche de la forme finale du support, puis on consolide le support à chaud par compression sous une pression de 5 à 35 MPa à une température de 450 à 650°C, sous atmosphère d'argon.

On recouvre ensuite la plaque d'une couche d'accrochage en titane.

On dépose ensuite sur la couche de titane un film de diamant de 60µm d'épaisseur par dépôt chimique en phase vapeur en utilisant un mélange d'acétone et d'oxygène et un plasma micro-onde. On obtient ainsi un film de diamant présentant les caractéristiques suivantes :
- conductivité thermique : 13 W/cm.°C
- diffusivité thermique : 7,4cm²/s
- coefficient d'expansion thermique : 0,8ppm/°C
- choc thermique par rapport à BeO : 926
- constante diélectrique : 5,2
- résistivité électrique : 10¹²-10¹⁴ohms.cm
- force diélectrique : 3445.10³V/cm (8750V/mil).

Les propriétés de conductivité thermique de ce film sont excellentes puisque la conductivité thermique est 3 à 4 fois celle des matériaux les plus conducteurs tels que le cuivre. De plus, le film de diamant offre une résistivité électrique très grande, est inerte chimiquement, non toxique et présente un coefficient de dilatation très faible (0,8 x 10-6/°C).

Le matériau composite à matrice métallique qui forme l'âme du support présente également des propriétés très intéressantes. En effet, il a une conductivité thermique plus élevée que celle de la matrice métallique en magnésium, il présente une stabilité dimensionnelle élevée, le coefficient de dilatation étant de -0,5 à 2,5.10⁻⁶/°C, il ne dégage aucune matière organique et il n'est pas sensible à l'humidité. Il est conducteur électrique et présente les propriétés mécaniques élevées données dans le tableau annexé.

Le support rigide ainsi obtenu peut donc être utilisé comme substrat pour les technologies de connexion par fils pour supporter par exemple, comme illustré sur la figure, un composant électronique 11 en céramique relié par des fils de connexion 13, par exemple en or ou en argent, à un circuit 15 obtenu par un procédé lithographique.

Avec un tel support, la chaleur dissipée par le composant 11 est immédiatement répartie sur la surface du support et transmise à l'âme en matériau composite grâce au film de diamant qui présente une conductivité thermique de 1300 W/m.°C.

Le coefficient de dilatation de l'ensemble est compatible avec celui de la céramique du composant, le coefficient de dilatation du support étant de 1 à 3.10⁻⁶/°C.

Le support est suffisamment rigide et résistant pour ne nécessiter aucun raidisseur, ce qui engendre un gain de masse significatif.

La surface du support en contact avec le composant est isolante alors que l'âme est conductrice et peut être utilisée pour la mise à la masse.

L'ensemble est parfaitement inerte et insensible au vieillissement par désorption de produits volatils.

La densité de l'ensemble est d'environ 2,5g/cm³, ce qui est très faible par rapport à la densité du diamant (3,51g/cm³) et par rapport à celle du Kovar (8,4g/cm³).

Le support de l'invention présente donc des propriétés uniques qui le rendent très avantageux pour des applications microélectroniques.

On a préparé de la même façon un support dans lequel le matériau composite était constitué d'une matrice en magnésium renforcée par des fibres de carbone THM commercialisées par Kazei sous la référence K 137.

Les propriétés mécaniques du matériau composite obtenu dans ces conditions sont données dans le tableau qui suit.

**TABLEAU**

| Propriété dans le sens des fibres | Composite unidirectionnel fibres FT700-Al | Composite unidirectionnel fibres K137-Mg |
|---|---|---|
| Module d'Young (GPa) | 150 | 300 |
| Contrainte à la rupture (MPa) | 600 | 1000 |
| Coefficient de dilatation (10⁻⁶/°C) | 0,2 | -0,5 |
| Reprise d'humidité | 0 | 0 |
| Conductivité thermique W/cm.°C | 3,4 | 2,9 |

Les supports peuvent être utilisés comme substrat de modules à multipuces (Multichip Modules) à la place des matériaux utilisés jusqu'à présent comme l'alumine, le silicium, le nitrure d'aluminium, le Kovar et le cuivre.

Sur la figure 2, on a représenté une variante de réalisation de l'élément de transfert thermique de la figure 1. Dans ce cas, l'élément comprend de plus un substrat métallique 21 non renforcé disposé entre deux ensembles 20 formés chacun d'une âme en matériau composite 1, d'une couche d'accrochage en titane 6 et d'un film de diamant 9.

Un tel élément pourrait bien entendu ne comporter qu'un seul ensemble 20 au-dessus du substrat 21.

Sur la figure 3, on a représenté un autre mode de réalisation de l'élément de transfert thermique de l'invention.

Dans ce cas, l'élément a la forme d'un boîtier ouvert. Le fond 30 de ce boîtier est formé de plusieurs ensembles superposés 33 comprenant chacun une âme en matériau composite 1, une couche d'accrochage 6 et un film de diamant 9 comme dans le cas de la figure 1.

Les parties latérales 34 formant la périphérie du boîtier sont réalisées uniquement en substrat métallique, c'est-à-dire en le même métal que celui formant la matrice métallique de l'âme 1 de chaque ensemble 30.

Ce dernier mode de réalisation est particulièrement intéressant pour des boîtiers destinés à l'encapsulation de modules multicomposants destinés à être connectés à des circuits de plus grande taille.

## Revendications

1. Elément de transfert thermique de la chaleur produite par une source de chaleur, qui comprend au moins un ensemble (20, 33) formé d'une âme en matériau composite (1) à matrice métallique (3) renforcée par des fibres inorganiques (5) sur laquelle est disposé un film isolant (9), le film isolant étant sur la surface de l'élément destinée à être en contact avec la source de chaleur (11,15), caractérisé en ce que le film isolant est un film de diamant.

2. Elément selon la revendication 1, caractérisé en ce que le film de diamant a une épaisseur de 0,25 à 150 µm, de préférence de 1 à 50 µm.

3. Elément selon la revendication 1 ou 2, caractérisé en ce que dans chaque ensemble une couche d'accrochage (7) est intercalée entre l'âme (1) et le film de diamant (9).

4. Elément selon la revendication 3, caractérisé en ce que la couche d'accrochage est en titane.

5. Elément selon l'une quelconque des revendications 1 à 4, caractérisé en ce que la matrice métallique de l'âme est en Al, Mg, Cu, Ti, un de leurs alliages ou un de leurs composés intermétalliques.

6. Elément selon l'une quelconque des revendications 1 à 5, caractérisé en ce que les fibres de renfort sont des fibres de carbone fortement graphitées à très haut module d'élasticité ou des fibres d'alumine.

7. Elément selon l'une quelconque des revendications 1 à 6, caractérisé en ce qu'il comprend de plus un substrat métallique (21).

8. Procédé de préparation d'un élément de transfert thermique selon l'une quelconque des revendications 1 à 7, caractérisé en ce que l'on forme chaque ensemble (20, 33) par dépôt chimique en phase vapeur d'un film de diamant (9) sur une âme en matériau composite (1) à matrice métallique (3) renforcée par des fibres inorganiques (5).

9. Procédé selon la revendication 8, caractérisé en ce qu'avant de déposer ledit film on réalise sur ladite âme une couche d'accrochage (7) en titane.

10. Procédé selon l'une quelconque des revendications 8 et 9, caractérisé en ce qu'il comprend de plus l'assemblage d'au moins deux ensembles (33) par brasage ou soudage par diffusion du film de diamant d'un ensemble sur l'âme en matériau composite de l'ensemble adjacent.

11. Support pour composant(s) électronique(s) (11, 15), caractérisé en ce qu'il est constitué par l'élément de transfert thermique selon l'une quelconque des revendications 1 à 7.

## Claims

1. Element for the heat transfer of the heat produced by a heat source, comprising at least one assembly (20, 33) formed by a composite material core (1) having a metallic matrix (3) reinforced by inorganic fibres (5), on which is placed an insulating film, the insulating film being located on the surface of the element which is to come into contact with the heat source (11, 15), characterized in that the insulating film being a diamond film (9).

2. Element according to claim 1, characterized in that the diamond film has a thickness of 0.25 to 150 µm, preferably 1 to 50 µm.

3. Element according to claim 1 or 2, characterized in that in each assembly an anchoring layer (7) is intercalated between the core (1) and the diamond film (9).

4. Element according to claim 3, characterized in that the anchoring layer is of titanium.

5. Element according to any one of the claims 1 to 4, characterized in that the metallic matrix of the core is of Al, Mg, Cu, Ti, one of their alloys or one of their intermetallic compounds.

6. Element according to any one of the claims 1 to 5, characterized in that the reinforcing fibres are highly graphitized carbon fibres having a very high modulus of elasticity or alumina fibres.

7. Element according to any one of the claims 1 to 6, characterized in that it also incorporates a metallic substrate (21).

8. Process for the preparation of a heat transfer element according to any one of the claims 1 to 7, characterized in that each assembly (20, 33) is formed by the chemical vapour phase deposition of a diamond film (9) on a composite material core (1) having a metallic matrix (3) reinforced by inorganic fibres (5).

9. Process according to claim 8, characterized in that prior to the deposition of the said film, a titanium anchoring layer (7) is formed on said core.

10. Process according to either of the claims 8 and 9, characterized in that it also involves the assembly of at least two assemblies (33) by brazing or welding by the diffusion of the diamond film from one assembly to the composite material core of the adjacent assembly.

11. Support for electronic components (11, 15), characterized in that it is constituted by the heat transfer element according to any one of the claims 1 to 7.

## Patentansprüche

1. Wärmeleitungselement der durch eine Wärmequelle erzeugten Wärme, das wenigstens einen Aufbau (20, 33) umfasst, der gebildet wird durch einen Verbundmaterial-Kern (1) mit einer Metallmatrix (3), verstärkt durch anorganische Fasern (5), auf dem eine dünne Isolierschicht (9) abgeschieden ist, wobei die dünne Isolierschicht sich auf derjenigen Oberfläche des Elements befindet, die dazu bestimmt ist, mit der Wärmequelle (11, 15) in Kontakt zu sein,
**dadurch gekennzeichnet**,
dass die dünne-Isolierschicht ein dünne Diamantschicht ist.

2. Element nach Anspruch 1, dadurch gekennzeichnet, dass die dünne Diamantschicht eine Dicke von 0,25 bis 150 µm hat, vorzugsweise von 1 bis 50 µm.

3. Element nach Anspruch 1 oder 2, dadurch gekennzeichnet, dass in jedem Aufbau zwischen dem Kern (1) und der dünnen Diamantschicht (9) eine Haftschicht (7) eingefügt ist.

4. Element nach Anspruch 3, dadurch gekennzeichnet, dass die Haftschicht aus Titan ist.

5. Element nach einem der Ansprüche 1 bis 4, dadurch gekennzeichnet, dass die metallische Matrix des Kerns aus Al, Mg, Cu, Ti, einer ihrer Legierungen oder einer ihrer intermetallischen Verbindungen ist.

6. Element nach einem der Ansprüche 1 bis 5, dadurch gekennzeichnet, dass die Verstärkungsfasern stark graphitierte Kohlenstofffasern mit sehr hohem Elastizitätsmodul oder Aluminiumfasern sind.

7. Element nach einem der Ansprüche 1 bis 6, dadurch gekennzeichnet, dass es außerdem ein metallisches Substrat (21) umfasst.

8. Verfahren zur Herstellung eines Wärmeleitungselements nach einem der Ansprüche 1 bis 7, dadurch gekennzeichnet, dass man jeden Aufbau (20, 23) durch chemische Gasphasenabscheidung einer dünnen Diamantschicht (9) auf einem Verbundmaterial-Kern (1) mit metallischer Matrix (3), verstärkt durch anorganische Fasern (5), bildet.

9. Verfahren nach Anspruch 8, dadurch gekennzeichnet, dass man vor dem Abscheiden der genannten dünnen Schicht auf demselben Kern eine Haftschicht (7) aus Titan erzeugt.

10. Verfahren nach einem der Ansprüche 8 und 9, dadurch gekennzeichnet, dass es außerdem den Zusammenbau von wenigstens zwei Aufbauten (33) durch Verlöten oder Verschweißen mittels Diffusion der dünnen Diamantschicht eines Aufbaus in den Verbundmaterial-Kern des benachbarten Aufbaus umfasst.

11. Träger für elektronisches Bauteil oder Bauteile (11, 15), dadurch gekennzeichnet, dass es durch es durch das Wärmeleitelement nach einem der Ansprüche 1 bis 7 gebildet wird.
